**Europäisches Patentamt**

**European Patent Office**

**Office européen des brevets**

(19)

(11) Veröffentlichungsnummer: **0 135 868**
**B1**

# (12) EUROPÄISCHE PATENTSCHRIFT

(45) Veröffentlichungstag der Patentschrift:
**27.01.88**

(21) Anmeldenummer: **84110626.3**

(22) Anmeldetag: **06.09.84**

(51) Int. Cl.⁴: **G 01 R 31/28**

(54) **Verfahren zur Aufnahme und Darstellung von Signalen im Innern integrierter Schaltungen unter Berücksichtigung der Flankensteilheit und Vorrichtung zur Durchführung eines solchen Verfahrens.**

(30) Priorität: **23.09.83 DE 3334534**

(43) Veröffentlichungstag der Anmeldung:
**03.04.85 Patentblatt 85/14**

(45) Bekanntmachung des Hinweises auf die Patenterteilung:
**27.01.88 Patentblatt 88/4**

(84) Benannte Vertragsstaaten:
**AT BE CH DE FR GB IT LI LU NL SE**

(56) Entgegenhaltungen:
**US - A - 4 045 736**

**ELECTRONICS INTERNATIONAL, Band 54, Nr. 14, 14. Juli 1981, Seiten 105-112, New York, USA; P. FAZEKAS et al.: "Scanning electron beam probes VLSI chips"**

(73) Patentinhaber: **Siemens Aktiengesellschaft Berlin und München, Wittelsbacherplatz 2, D-8000 München 2 (DE)**

(72) Erfinder: **Fazekas, Peter, Dipl.-Ing., Stuntzstrasse 21, D-8000 München 80 (DE)**

# Beschreibung

Die Erfindung betrifft ein Verfahren zur Aufnahme und Darstellung von Signalen im Innern integrierter Schaltungen nach dem Oberbegriff des Anspruchs 1 sowie eine Vorrichtung zur Durchführung dieses Verfahrens.

Bei der internen Prüfung digitaler integrierter Schaltungen müssen in erster Linie die zeitliche Lage und die Steilheiten der Signalflanken bestimmt werden.

Dies ist durch die quantitative Signalverlaufsmessung möglich, beispielsweise mit Hilfe der Elektronenstrahl-Messtechnik, aber sehr zeitaufwendig. Mit der Logikanalyse werden zwar die Zustandsänderungen bei der internen Prüfung digitaler integrierter Schaltungen schnell erfasst. Die Logikanalyse liefert aber keine Aussage über Flankensteilheiten von Signalen im Innern integrierter Schaltungen.

Der vorliegenden Erfindung liegt die Aufgabe zugrunde, ein Verfahren der eingangs genannten Art anzugeben, mit dem Signale im Innern digitaler Schaltungen rasch derart aufgenommen werden können, dass auch die zeitliche Lage und die Steilheiten von Signalflanken bestimmt werden können.

Diese Aufgabe wird erfindungsgemäss durch ein Verfahren nach Anspruch 1 gelöst.

Ausgestaltungen und Vorteile der Erfindung sind in den Unteransprüchen, der Beschreibung und der Zeichnung dargestellt.

Eine Sonde, beispielsweise ein gepulster Elektronenstrahl oder ein Laser-Scanner, wird auf eine Messstelle im Innern einer digitalen integrierten Schaltung gerichtet und löst dort Teilchen, beispielsweise Sekundärelektronen, aus, welche Information über den Potentialverlauf an dieser Messstelle liefern. Wie mit Hilfe einer Elektronensonde ein Potentialverlauf abgetastet werden kann, ist beispielsweise in der US-Patentschrift 4 277 679 oder in Electonics International, Vol. 54 (1981), July, No. 14, S. 105–112 beschrieben. Im Gegensatz zur Logikanalyse werden bei einem erfindungsgemässen Verfahren ein unterer und ein oberer Schwellwert für den aufgenommenen Signalverlauf berücksichtigt. Da bei dem bekannten Verfahren der Logikanalyse nur ein einziger Schwellwert berücksichtigt wird, kann bei diesem bekannten Verfahren der Logikanalyse ein Digitalsignal nur so dargestellt werden, dass es entweder den Zustand «0» oder den Zustand «1» annimmt. In einer Darstellung eines Digitalsignals, welches mit Hilfe des bekannten Verfahrens der Logikanalyse aufgenommen worden ist, gibt es nur abrupte Übergänge zwischen den beiden Zuständen «0» und «1». Da es bei einem erfindungsgemässen Verfahren einen oberen und einen unteren Schwellwert zur Signalaufnahme gibt, gibt es bei der Wiedergabe eines in erfindungsgemässer Weise aufgenommenen Digitalsignals Bereiche, wo dieses wiedergegebene Digitalsignal den Wert «0» annimmt, und es gibt Bereiche, wo dieses Digitalsignal den Wert «1» annimmt. Darüber hinaus gibt es auch noch Bereiche, wo dieses mit Hilfe eines erfindungsgemässen Verfahrens aufgenommene Digitalsignal weder den Wert «0» noch den Wert «1» annimmt, sondern wo sich dieses Digitalsignal in einem Übergang entweder vom Wert «0» zum Wert «1» oder vom Wert «1» zum Wert «0» befindet. Da bei der Wiedergabe ein Digitalsignal als Funktion der Zeit wiedergegeben wird, entspricht ein schmaler Übergangsbereich zwischen zwei verschiedenen logischen Pegeln einem steilen Flankenanstieg bzw. Flankenabfall und ein breiter Übergangsbereich zwischen zwei verschiedenen logischen Pegeln einem relativ flachen Flankenanstieg bzw. Flankenabfall. Die beiden Schwellwerte, die bei einem erfindungsgemässen Verfahren verwendet werden, können an die jeweils zu untersuchende Logikfamilie in ähnlicher Weise angepasst werden, wie bei dem bekannten Verfahren der Logikanalyse der dort verwendete einzige Schwellwert an die dort jeweils zu untersuchende Logikfamilie angepasst werden kann.

Da es bei dem bekannten Verfahren der Logikanalyse nur einen einzigen Schwellwert gibt, gibt es bei diesem bekannten Verfahren nur die beiden Möglichkeiten, dass ein Signalwert entweder oberhalb dieses Schwellwertes ist oder unterhalb dieses Schwellwertes ist. Bei einem erfindungsgemässen Verfahren mit einem oberen Schwellwert und einem unteren Schwellwert gibt es drei Möglichkeiten, nämlich einmal, dass der Signalwert oberhalb des oberen Schwellwertes ist, zum zweiten, dass der Signalwert zwischen dem unteren und dem oberen Schwellwert ist, und zum dritten, dass der Signalwert unterhalb des unteren Schwellwertes sich befindet. Befindet sich der Signalwert zwischen dem unteren und dem oberen Schwellwert, so liegt ein Übergangsbereich zwischen dem unteren logischen Pegel und dem oberen logischen Pegel vor.

Die Messgeschwindigkeit kann bei einem erfindungsgemässen Verfahren dadurch erhöht werden, dass die Abtastung des Signals an einem inneren Punkt einer digitalen Schaltung zunächst in groben Schritten oder mit breitem Abtastpuls erfolgt, solange bis ein Übergangsbereich zwischen oberem und unterem Schwellwert, d.h. eine Signalflanke, erkannt wird. Durch Feinabtastung in der Umgebung dieses Übergangsbereiches zwischen oberem und unterem Schwellwert, d.h. der Signalflanke, kann die Lage dieser Signalflanke und ihre Steilheit genau bestimmt werden. Das Ergebnis dieser Bestimmung kann in stark komprimierter Form abgespeichert werden, wie z.B. eine Information darüber, ob die Signalflanke steigend oder fallend ist, eine Information über die zeitliche Lage dieser Signalflanke und eine weitere Information über die Steilheit dieser Signalflanke.

Zur Wiedergabe eines mit einem erfindungsgemässen Verfahren aufgenommenen Digitalsignals empfiehlt sich eine Darstellung ähnlich einer Logikdiagramm-Darstellung. Bei einer solchen Wiedergabe eines mit einem erfindungsgemässen Verfahren gewonnenen Digitalsignals werden nur die logischen Pegel «0» und «1» dargestellt. Die Zustandsübergänge werden durch geneigte Linien entsprechend den gemessenen Flankensteilheiten angegeben.

Die Steuerung der Messwertaufnahme erfolgt vorzugsweise mit einer programmierten Ablaufsteuerung, z.B. mit einem Mikrocomputersystem.

Mit einem erfindungsgemässen Verfahren können nicht nur Digitalsignale an Punkten im Innern von digitalen Schaltungen aufgenommen werden, sondern auch an Ausgängen von digitalen Schaltungen.

Die Erfindung wird im folgenden anhand der Zeichnung näher erläutert.

Fig. 1 erläutert das der Erfindung zugrundeliegende Prinzip.

Fig. 2 zeigt eine Einrichtung zur Einstellung eines Schwellwertes.

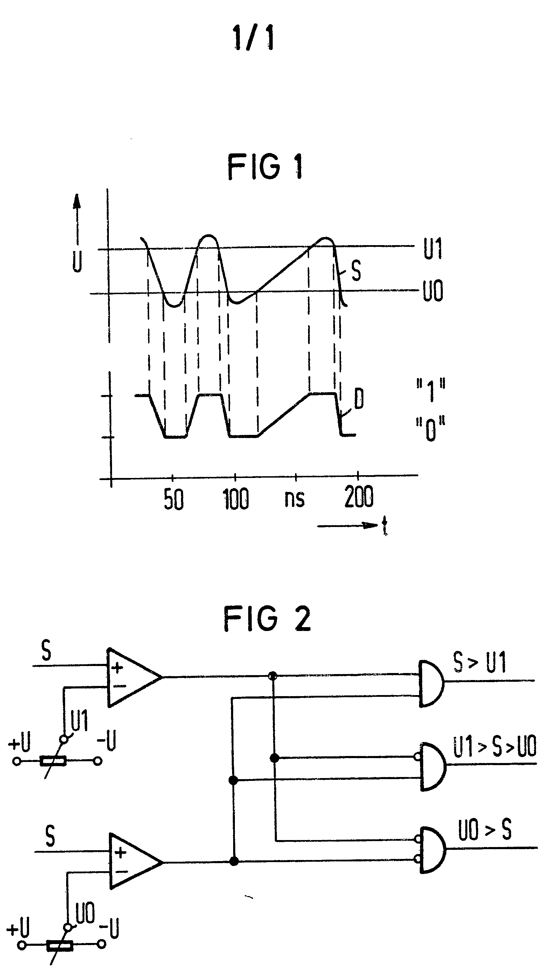

Fig. 1 erläutert das der Erfindung zugrundeliegende Prinzip. Im oberen Teil dieser Fig. 1 ist das an einem Messpunkt vorliegende Signal S und seine Zuordnung zu den beiden Schwellwerten, nämlich dem unteren Schwellwert U0 und dem oberen Schwellwert U1, dargestellt. Im unteren Teil dieser Fig. 1 ist das aus diesem am Messpunkt vorhandenen Signal S gewonnene Messsignal D dargestellt. Beide Signale S und D sind als Funktionen der Zeit t angegeben. Die Spannungswerte U des am Messpunkt vorliegenden Signals S sind also als Funktion der Zeit t dargestellt. Zunächst weist das Signal S eine Spannung U auf, die grösser als der obere Schwellwert U1 ist. Daher nimmt das digitale Messignal D zunächst den logischen Wert «1» an. Sodann fällt das Signal S mit einer relativ steilen Flanke unter den unteren Schwellwert U0 ab. Daher zeigt das Signal D zunächst einen steilen Signalabfall, um sodann den logischen Wert «0» anzunehmen. Nach einem wiederum relativ steilen Anstieg des Signals S über den oberen Schwellwert U1 hinaus und einem wiederum steilen Flankenabfall des Signals S unter den Wert U0 erfolgt ein relativ flacher Signalanstieg wiederum über den oberen Schwellwert U1 hinaus und schliesslich ein relativ steiler Signalabfall unter den unteren Schwellwert Uo. Das Signal D spiegelt dieses Auf und Ab des Signals S in vereinfachter Form wider, wobei jedoch im Gegensatz zum bekannten Stand der Technik das Digitalsignal D nicht nur entweder den logischen Wert «0» oder den logischen Wert «1» annimmt, sondern in Übergangsbereichen zwischen diesen beiden logischen Werten die Lage und die Steilheit der Anstiegsflanken und Abfallflanken des am Messpunkt vorliegenden Signals S wiedergibt. Damit wird eine Beurteilung der dynamischen Eigenschaften von Schaltungsteilen ermöglicht.

Fig. 2 zeigt eine Einrichtung zur Einstellung eines Schwellwertes. Eine Einrichtung zur Bestimmung eines Schwellwertes besteht im wesentlichen aus einem Komparator, dessen Minus-Eingang als Referenzspannung für einen oberen Schwellwert U1 bzw. für einen unteren Schwellwert U0 eingestellt werden kann. Am Plus-Eingang eines solchen Komparators wird jeweils das Signal S angelegt. Da eine Vorrichtung zur Durchführung eines erfindungsgemässen Verfahrens einen oberen Schwellwert U1 und einen unteren Schwellwert U0 benötigt, werden also für eine Vorrichtung zur Durchführung eines erfindungsgemässen Verfahrens zwei Komparatoren vorgesehen, an deren Plus-Eingänge jeweils das am Messpunkt abgenommene Signal S angelegt wird. Am Minus-Eingang des Einrichtung zur Bestimmung des oberen Schwellwertes U1 wird als Referenzspannung eine diesem oberen Schwellwert U1 entsprechende Spannung angelegt. Am Minus-Eingang der Einrichtung zur Bestimmung des unteren Schwellwertes U0 wird als Referenzspannung eine dem unteren Schwellwert U0 entsprechende Spannung angelegt. Am Ausgang der Einrichtung zur Festlegung des oberen Schwellwertes U1 ergibt sich eine logische «1», wenn der Wert des Signals S grösser ist als der obere Schwellwert U1 und eine logische «0», wenn der Wert des Signals S kleiner ist als der obere Schwellwert U1. Am Ausgang der Einrichtung zur Bestimmung des unteren Schwellwertes U0 ergibt sich eine Logische «1», wenn der Wert des Signals S grösser ist als der untere Schwellwert U0 und eine logische «0», wenn der Wert des Signals S kleiner ist als der untere Schwellwert U0. Werden die beiden Ausgänge der beiden Komparatoren in einem logischen UND-Verknüpfungsglied zusammengefasst, so ergibt sich als Ausgang dieses UND-Verknüpfungsgliedes eine logische «1» für den Fall, dass der Wert des Signals S grösser ist als der obere Schwellwert U1. Wird der invertierte Ausgang der Einrichtung zur Festlegung des oberen Schwellwertes U1 mit dem Ausgang der Einrichtung zur Festlegung des unteren Schwellwertes U0 in einem logischen UND-Verknüpfungsglied zusammengefasst, so ergibt sich am Ausgang dieses UND-Verknüpfungsgliedes eine logische «1» für den Fall, dass der Wert des Signals S grösser als der untere Schwellwert U0 und kleiner als der obere Schwellwert U1 ist. Werden die invertierten Ausgänge der beiden Einrichtungen zur Festlegung des oberen und den unteren Schwellwertes in einem logischen UND-Verknüpfungsglied zusammengefasst, so ergibt sich am Ausgang dieses UND-Verknüpfungsgliedes eine logische «1» für den Fall, dass der Wert des Signals S kleiner ist als der untere Schwellwert U0.

**Patentansprüche**

1. Verfahren zur Aufnahme und Darstellung von Signalen (S) an integrierten Schaltungen, wobei die Signale (S) zwei logische Pegel aufweisen, dadurch gekennzeichnet, dass für beide logische Pegel jeweils ein Schwellwert (U0, U1) definiert wird und dass mit Hilfe dieser Schwellwerte (U0, U1) ein Messignal (D) gewonnen wird, welches die zeitliche Lage und die Steilheit einer Signalflanke eines an einem Messpunkt vorliegenden Signals (S) wiedergibt.

2. Verfahren nach Anspruch 1, dadurch gekennzeichnet, dass das Abtasten eines Signals (S) in grösseren Abständen erfolgt, bis eine Signalflanke erkannt wird, und dass dann durch Feinabtastung des Signals (S) in der Umgebung der Signalflanke die Lage und Steilheit dieser Signalflanke genau bestimmt wird.

3. Verfahren nach Anspruch 1 oder 2, dadurch gekennzeichnet, dass das Ergebnis der Messung in stark komprimierter Form abgespeichert wird.

4. Verfahren nach einem der Ansprüche 1 bis 3, dadurch gekennzeichnet, dass zur Wiedergabe eines Zeitdiagrammes eines aufgenommenen Signals (S) nur zwei logische Pegel (U0, U1) verwendet werden, wobei Übergänge zwischen diesen beiden logischen Pegeln (U0, U1) durch geneigte Linien entsprechend den gemessenen Flankensteilheiten angegeben werden.

5. Vorrichtung zur Durchführung eines Verfahrens nach einem der Ansprüche 1 bis 3, gekennzeichnet durch eine Einrichtung zur Erzeugung eines oberen Schwellwertes (U1) und eines unteren Schwellwertes (U0), mit deren Hilfe ein Messsignal gewonnen wird.

**Revendications**

1. Procédé pour prélever et représenter des signaux (S) de circuits intégrés, les signaux (S) présentant deux niveaux logiques, caractérisé en ce que l'on définit un seuil (U0, U1) pour chacun des deux niveaux logiques et que, à l'aide de ces seuils (U0, U1), on produit un signal de mesure (D) qui indique la position dans le temps et la raideur d'un flanc d'un signal (S) présent sur un point de mesure.

2. Procédé selon la revendication 1, caractérisé en ce que l'on échantillonne un signal (S) à intervalles relativements grands, jusqu'à la détection d'un flanc de signal, et que l'on détermine ensuite exactement la position et la raideur de ce flanc de signal par échantillonnage fin du signal (S) aux abords du flanc.

3. Procédé selon la revendication 1 ou 2, caractérisé en ce que l'on mémorise le résultat de la mesure sous une forme fortement comprimée.

4. Procédé selon une des revendications 1 à 3, caractérisé en ce que l'on utilise seulement deux niveaux logiques (U0, U1) pour représenter un diagramme en fonction du temps d'un signal (S) prélevé, diagramme dans lequel des transitions entre ces deux niveaux logiques (U0, U1) sont indiquées par des lignes inclinées en fonction des raideurs de flancs mesurées.

5. Dispositif pour la mise en œuvre d'un procédé selon une des revendications 1 à 3, caractérisé par un dispositif pour générer un seuil supérieur (U1) et un seuil inférieur (U0), à l'aide desquels on produit un signal de mesure.

**Claims**

1. A method of picking-up and representing signals (S) in integrated circuits, where the signals (S) have two logic levels, characterised in that a threshold value (U0, U1) is defined for each of the two logic levels, and that by means of these threshold values (U0, U1) a measurement signal (D) is obtained which reproduces the time position and the gradient of a signal flank of a signal (S) occurring at a measurement point.

2. A method as claimed in claim 1, characterised in that a signal (S) is sampled at long intervals until a signal flank is recognised, and that then the position and gradient of the signal flank are firstly determined by fine sampling of the signal (S) in the vicinity of the signal flank.

3. A method as claimed in claim 1 or 2, characterised in that the result of the measurement is stored in a highly compressed form.

4. A method as claimed in one of the claims 1 to 3, characterised in that only two logic levels (U0, U1) are used to reproduce a time diagram of a recorded signal (S), where transitions between these two logic levels (U0, U1) are indicated by sloping lines which correspond to the measured flank gradients.

5. A device for carrying out a method claimed in one of the claims 1 to 3, characterised by a device which generates an upper threshold value (U1) and a lower threshold value (U0), with the aid of which a measurement signal is obtained.

# FIG 1

# FIG 2